# EUROPEAN PATENT APPLICATION

(11) **EP 4 335 902 A1**
(43) Date of publication of application: **13.03.2024**
(21) Application number: 22194425.9
(22) Date of filing: 07.09.2022
(51) Int. Cl.: C08L 35/06, C08F 257/02, H01B 3/30, H01B 3/44

(54) **LOW DIELECTRIC LOSS THERMOSETTING RESIN COMPOSITION**

(71) Applicant: Polyscope Polymers B.V., 6161CZ Geleen (NL)
(72) Inventor: The designation of the inventor has not yet been filed
(74) Representative: Vandevijver, Pascale

(57) **Abstract**

The present disclosure relates to a low dielectric loss thermosetting resin composition comprising a copolymer comprising a monomer unit of Formula I and aliphatic unsaturated imide monomer unit of Formula II and at least one curing agent comprising maleimide, (meth)acrylate or vinyl groups. 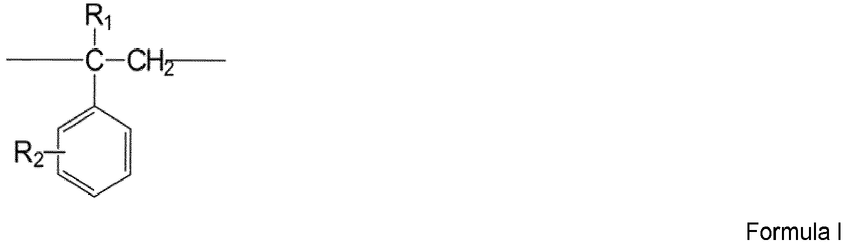 wherein R1 represents a hydrogen or aliphatic group and R2 represents a hydrogen, an aliphatic or aromatic group and 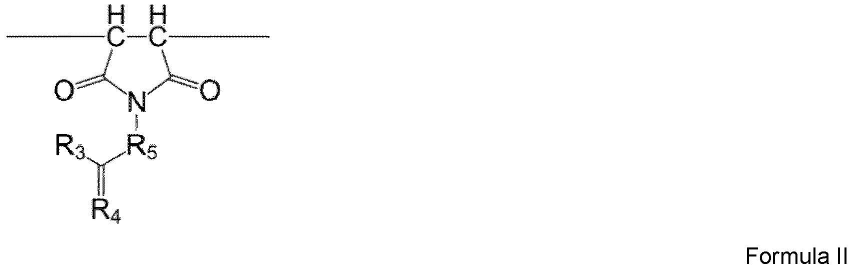 wherein R3 is H or an alkyl group, R4 is an alkylidene group and R5 is an alkanediyl group

The curing agent comprising maleimide, (meth)acrylate or vinyl groups is preferably polyfunctional. The resin composition optionally can contain a radical initiator. The resin composition may further comprise additives selected from flame retardants, fillers, coupling agents. The invention further relates to a prepreg or a copper clad laminate comprising the thermoset resin composition.

## Description

### TECHNICAL FIELD

This disclosure relates to polymers of thermosetting resin compositions that are useful in the chemical arts, such as in the manufacture of products, such as printed circuit boards. In particular, the present disclosure pertains to novel compositions and processes for preparing certain low dielectric loss thermosetting resin polymers.

### BACKGROUND

The present disclosure relates to a low dielectric loss thermosetting resin composition comprising a copolymer containing monomer units of vinyl-or vinyl derivatives, aliphatic unsaturated imides and a curing agent. The disclosure further relates to a prepreg and a metal clad laminate comprising the thermoset resin composition. The present disclosure also relates to the printed circuit boards comprising the prepreg and/ or metal clad laminate.

Thermosetting resin compositions are known in the art. Thermosetting resins undergo a curing or crosslinking process that will crosslink polymer chains and thus connect the entire matrix together in a three-dimensional network. Once crosslinked, thermosetting resins cannot be remelted or reformed. Thermosetting resins tend to have high dimensional stability, high-temperature resistance, and good resistance to solvents because of their three-dimensional cross-linked structure (U.S. Congress, Office of Technology Assessment, June 1988).

Crosslinked thermosetting resin compositions such as epoxy resins, phenolic resins, bismaleimide resins, polyamine formaldehyde resins and silicone resins are useful in electrical applications and electronic equipment such as in printed circuit boards (PCB's). Thermosetting resins are required to provide a long life and high reliability of electrically insulating properties. Such compositions are for example used as fiber reinforced prepregs, and in metal clad laminates such as copper-clad laminates (CCL) which are suitable for printed circuit boards (PCB).

CCL play a role as a leading fundamentally raw material contributing to materials for PCB fabrication, performing four functions including conductivity, insulation, supporting and signal transmission and thereby determine PCB's performance, quality, fabrication level, fabrication cost and long-term reliability. Constant development of PCB's and increasing application demands of electronic products gradually bring forward new technological demands for CCL, simultaneously providing driving force to technological development and fabrication technology progress of CCL.

Epoxy resins are commonly used for CCL. Curing agents for epoxy resins are for example phenolic, poly(styrene-co-maleic anhydride) (SMA), benzoxazine, active esters and cyanate esters. The epoxy resin formulations can however not meet the increasing need for lower dielectric loss. This is mainly due to the polar groups that are formed during the curing of the epoxy resins, which will negatively influence the dielectric loss.

In US9245667 unsaturated based thermosetting compositions are disclosed which achieve better dielectric properties. Often unsaturated di-functional low molecular weight poly(phenylene ether) (PPE) is used with additional curing agents like e.g. triallyl isocyanurate (TAIC), bismaleimide (BMI), polybutadiene and polybutadiene-co-styrene. Disadvantage of these low molecular PPE resins is that PPE could have flow issues at the curing stage and could not have good wettability to glass cloth.

Fluorine-containing resins such as PTFE, can also be used for PCB's and show a low dielectric loss. However, fluorine-containing resins are expensive and not easy to work with and thus limited in use.

In JP-A-58019316 a thermosetting resin composition is disclosed providing improved heat resistance and thus improved insulating properties whereby a thermoset resin composition is provided by mixing a styrene copolymer having a specific imide bond with a radical polymerization catalyst. The styrene copolymer preferably comprises styrene with maleic anhydride which undergoes an imidization reaction with for example allylamine. The resulting copolymer is heated in the presence of a known radical polymerization catalyst such as an organic peroxide to obtain the heat-resistant thermosetting resin. A disadvantage of this cured thermosetting resin is that it still has a relatively high dielectric loss even at the reported 1 MHz. The dielectric loss increases when the frequency increases, while higher frequencies, e.g. 1 GHz or above, are commonly used for the high speed PCB applications. Moreover, the cured resin shows a relatively low decomposition temperature i.e. poor thermostability. Thermostability can influence the processability and the operation temperature. For instance, poor thermostability would lead to short delamination time during soldering process for PCB applications, and could also cause thermal reliability and signal integrity issues during operation.

Thermosetting resins used in the high speed applications must thus satisfy a number of critical thermal, environmental, and electrical requirements to meet the required performance criteria for microelectronics applications. These desired attributes include thermal stability, low moisture uptake, copper adhesion, high breakdown voltage (low leakage current), low dielectric constant (Dk) and low dielectric loss (Df) which can be also called loss tangent.

Therefore, there is a need to develop a thermosetting resin composition with excellent dielectric properties such as low dielectric constant (Dk) and low dielectric loss (Df) combined with other properties such as high Tg, low coefficient of thermal expansion and low water absorption and high peel strength as required in the high speed PCB's.

It is an object of the present disclosure to provide a thermosetting resin composition, with improved dielectric and thermal properties, that can be used in electronic applications such as the high speed PCB's. By improved dielectric properties is meant a low dielectric loss and low dielectric constant (Dk) or low Relative Permittivity combined with a better thermostability.

### SUMMARY

In one aspect, the disclosure provides a thermosetting resin composition comprising a copolymer comprising a monomer unit of Formula I 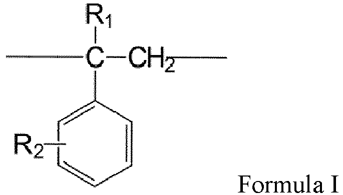 wherein R1 represents a hydrogen or aliphatic group and R2 represents a hydrogen, an aliphatic or aromatic group, and an aliphatic unsaturated imide of Formula II 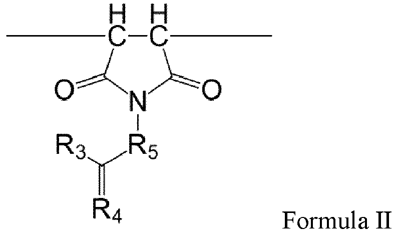 wherein R3 is H or an alkyl group, R4 is an alkylidene group and R5 is an alkanediyl group; and at least one curing agent comprising maleimide, (meth)acrylate or vinyl groups.

In another aspect, the disclosure provides a thermoset resin composition prepared by a process comprising the steps of (i) contacting a styrene-maleic anhydride copolymer (SMA) with an unsaturated aliphatic amine to prepare the styrene-maleimide copolymer and/or (ii) crosslinking a styrene-maleimide copolymer with an at least one curing agent.

In another aspect, the disclosure provides a thermoset resin composition comprising a styrene-maleimide copolymer crosslinked by at least one curing agent.

In another aspect, the disclosure provides a prepreg comprising a thermosetting resin composition or a thermoset resin composition as described herein, or a semi-cured product of a thermosetting resin composition or a thermoset resin composition as described herein; and a substrate.

In another aspect, the disclosure provides a metal clad laminate comprising an insulating layer formed out of a cured product of a prepreg composition as described herein or a thermoset resin composition as described herein; and at least one metal layer formed on either or both surfaces of the insulating layer.

In another aspect, the disclosure provides a printed circuit board comprising a prepreg composition as described herein, or a thermoset resin composition as described herein, or a metal clad laminate as described herein.

Additional embodiments, features, and advantages of the disclosure will be apparent from the following detailed description and through practice of the disclosure. The compounds of the present disclosure can be described as embodiments in any of the following enumerated clauses. It will be understood that any of the embodiments described herein can be used in connection with any other embodiments described herein to the extent that the embodiments do not contradict one another.
1. A thermosetting resin composition comprising a copolymer comprising a monomer unit of Formula I 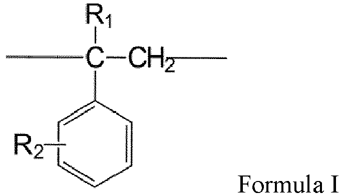 wherein R1 represents a hydrogen or aliphatic group and R2 represents a hydrogen, an aliphatic or aromatic group, and an aliphatic unsaturated imide of Formula II 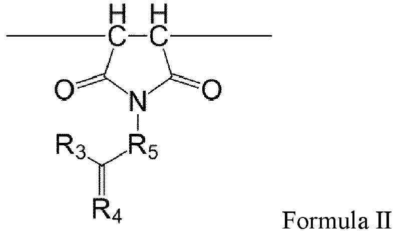 wherein R3 is H or an alkyl group, R4 is an alkylidene group and R5 is an alkanediyl group, and at least one curing agent comprising maleimide, (meth)acrylate or vinyl groups.
2. The thermosetting resin composition according to clause 1 whereby the maleimide curing agent is a polyfunctional maleimide.
3. The thermosetting resin composition according to clause 2 whereby the polyfunctional maleimide is chosen from the group consisting of bisphenol A diphenyl ether bismaleimide, 3,3'-dimethyl-5,5'-diethyl-4,4'-diphenylmethane bismaleimide, biphenyl containing maleimide, meta-arylene containing maleimide or 1,6-bismaleimide-(2,2,4-trimethyl)hexane.
4. The thermosetting resin composition according to any one of the clauses 1-2 whereby the curing agent comprising (meth)acrylate groups is a polyfunctional (meth)acrylate.
5. Thermosetting resin composition according to clause 4 whereby the polyfunctional (meth)acrylate is represented by Formula XI 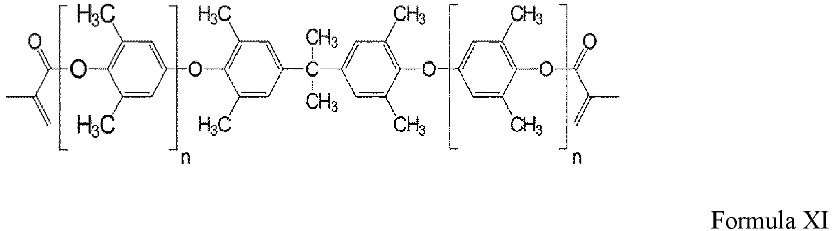 n is an integer between 1-20
6. The thermosetting resin composition according to any one of the clauses 1-2 whereby the curing agent comprising vinyl group is a polyfunctional vinyl containing curing agent.
7. The thermosetting resin composition according to clause 6 whereby the polyfunctional vinyl curing agent is selected from the group consisting of polybutadiene, polybutadiene-co-styrene, divinylbenzene, bis-vinylphenyl ethane, polyfunctional vinyl aromatic copolymer, vinyl cyclic olefin resin or a poly(arylene ether).
8. The thermosetting resin composition according to clause 7 whereby the poly(arylene ether) is represented by Formula XII. 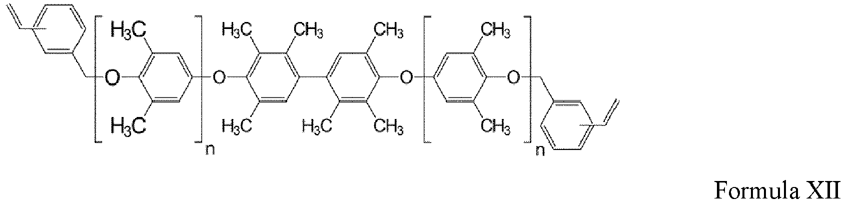 n is an integer between 1-20
9. The thermosetting resin composition according to any one of the clauses 1-8 further comprising a radical initiator.
10. The thermosetting resin composition according to clause 1 whereby the molar ratio of monomer unit of Formula I versus the unsaturated imide monomer unit of Formula II varies from 1:1 to 9:1.
11. The thermosetting resin composition according to clause 1 whereby the copolymer further comprises saturated imide monomer units of Formula III. 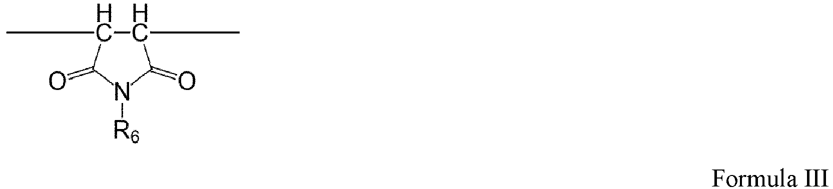 Whereby R6 is chosen from saturated aliphatic or aromatic groups.
12. The thermosetting resin composition according to clause 11 whereby the molar ratio unsaturated imide monomer unit of Formula II versus the saturated imide monomer unit of Formula III varies from 1:0 to 1:2.
13. The thermosetting resin composition according to any one of the clauses 1-12 further comprising at least one additive selected from flame retardants, fillers, coupling agents and any combination thereof.
14. A prepreg comprising the thermosetting resin composition according to any one of the clauses 1-13 or a semi-cured product of the resin composition and a substrate.
15. Metal clad laminate comprising an insulating layer formed out of a cured product of the prepreg of clause 14 and at least one metal layer formed on either or both surfaces of the insulating layer.
16. Printed circuit board comprising the metal clad laminate according to clause 15.
17. A thermoset resin composition prepared by a process comprising the step of
   (ii) crosslinking a styrene-maleimide copolymer with an at least one curing agent.
18. The thermoset resin composition of clause 17, further comprising the step of
   (i) contacting a styrene-maleic anhydride copolymer (SMA) with an unsaturated aliphatic amine to prepare the styrene-maleimide copolymer.
19. The thermoset resin composition of clause 17 or 18, wherein the styrene-maleimide copolymer comprises a monomer unit of Formula I 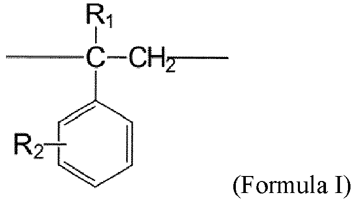 wherein R1 is a hydrogen or an aliphatic group, and R2 is a hydrogen, an aliphatic group, or an aromatic group; and
   an aliphatic unsaturated imide of Formula II 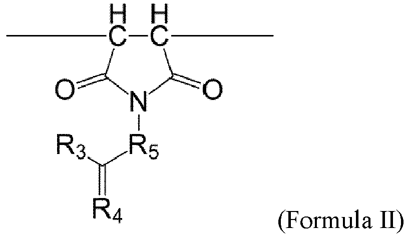 wherein R3 is H or an aliphatic group, R4 is an alkylidene group, and R5 is an alkylene group.
20. The thermoset resin composition of any one of clauses 17-19, wherein the styrene-maleimide copolymer further comprises a saturated imide monomer of Formula III, 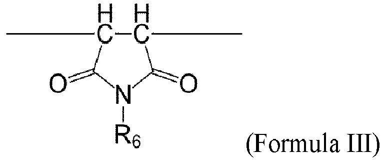 wherein R6 is a saturated aliphatic or an aromatic group.
21. The thermoset resin composition of any one of clauses 17-20, wherein the at least one curing agent comprises one or more maleimide group, (meth)acrylate group, and/or vinyl group.
22. The thermoset resin composition of any one of clauses 17-20, wherein the at least one curing agent comprises a polyfunctional maleimide.
23. The thermoset resin composition of clause 22, wherein the polyfunctional maleimide is selected from bisphenol A diphenyl ether bismaleimide, 3,3'-dimethyl-5,5'-diethyl-4,4'-diphenylmethane bismaleimide, biphenyl containing maleimide, meta-arylene containing maleimide, and 1,6-bismaleimide-(2,2,4-trimethyl)hexane.
24. The thermoset resin composition of any one of clauses 17-20, wherein the at least one curing agent is a polyfunctional (meth)acrylate.
25. The thermosetting resin composition of clause 24, wherein the polyfunctional (meth)acrylate is of the Formula XI, 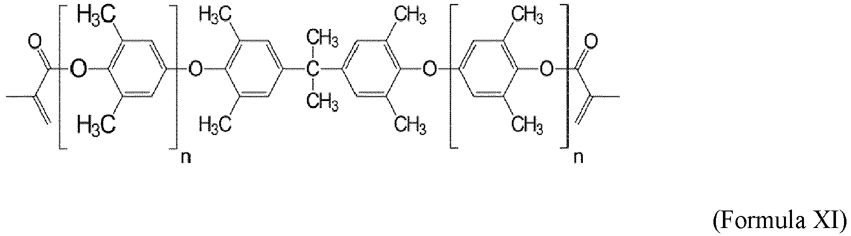 wherein n is an integer between 1-20.
26. The thermoset resin composition of any one of clauses 17-20, wherein the at least one curing agent is a polyfunctional vinyl containing curing agent.
27. The thermoset resin composition of clause 26, wherein the polyfunctional vinyl containing curing agent is selected from polybutadiene, polybutadiene-co-styrene, divinylbenzene, bis-vinylphenyl ethane, polyfunctional vinyl aromatic copolymer, vinyl cyclic olefin resin, and poly(arylene ether).
28. The thermoset resin composition of clause 27, wherein the poly(arylene ether) is of the Formula XII, 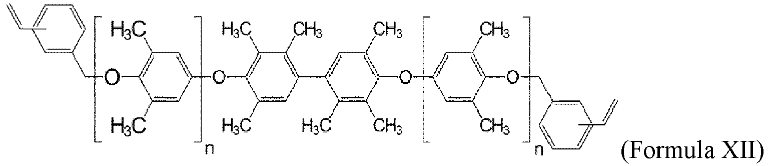 wherein n is an integer between 1-20.
29. The thermoset resin composition of any one of clauses 17-28, wherein step (ii) is carried out in the presence of one or more radical polymerization initiator.
30. The thermoset resin composition of clause 29, wherein the one or more radical polymerization initiator comprises an azo compound or an organic peroxide.
31. The thermoset resin composition of clause 30, wherein the azo compound is azobisisobutyronitrile, 2,2'-azobis(2-methylbutyronitrile), 2,2'-azobis(2,4,4-trimethylpentane, 2,2'-azobis(N-butyl-2-methylpropionamide.
32. The thermoset resin composition of clause 30, wherein the organic peroxide is selected from the group consisting of benzoyl peroxide, t-butyl hydroperoxide, dicumyl peroxide, t-butyl perbenzoate, methylethyl ketone peroxide, cyclohexanone peroxide, acetyl peroxide, di-t-butyl peroxide, t-butyl perbenzoate, di(2-tert.butylperoxy-isopropyl)benzene, 2,5-dimethyl-2,5-di(tert.butylperoxy)hexyne-3), and cumene hydroperoxide.
33. The thermoset resin composition of any one of clauses 18-32, wherein the molar ratio of monomer unit of Formula I to the unsaturated imide monomer unit of Formula II in the styrene-maleimide copolymer is from about 1:1 to 9:1.
34. The thermoset resin composition of any one of clauses 19-33, wherein the molar ratio unsaturated imide monomer unit of Formula II to the saturated imide monomer unit of Formula III is from about 1:0 to 1:2.
35. The thermoset resin composition of any one of clauses 17-34, wherein step (ii) is carried out in the presence of at least one additive selected from the group consisting of flame retardants, fillers, coupling agents, and a combination thereof.
36. The thermoset resin composition of any one of clauses 17-35, wherein step (ii) is carried out with heating.
37. The thermoset resin composition of any one of clauses 17-36, wherein step (ii) is carried out in the presence of a substrate.
38. The thermoset resin composition of clause 37, wherein step (ii) is carried out with heating that does not provide complete curing of the thermoset resin composition, wherein the incomplete curing provides a prepreg composition of the thermoset resin composition.
39. A metal clad laminate comprising the thermoset resin composition of clause 38, prepared by a process comprising contacting the thermoset resin composition with one or more metal layers prior to completion of step (ii).
40. The metal clad laminate of clause 40 comprising,
   i.) an insulating layer comprising the thermoset rein of clause 37, and
   ii.) one or more metal layers. wherein the one or more metal layers are on either or both surfaces of the insulating layer.
41. A printed circuit board comprising the prepreg of clause 38, or the metal clad laminate of clause 40.
42. A thermoset resin composition comprising a styrene-maleimide copolymer crosslinked by at least one curing agent.
43. The thermoset resin composition of clause 42, wherein the styrene-maleimide copolymer comprises a monomer unit of Formula I 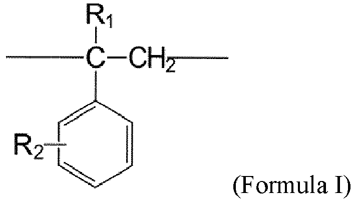 wherein R1 is a hydrogen or an aliphatic group, and R2 is a hydrogen, an aliphatic group, or an aromatic group; and
   an aliphatic unsaturated imide of Formula II 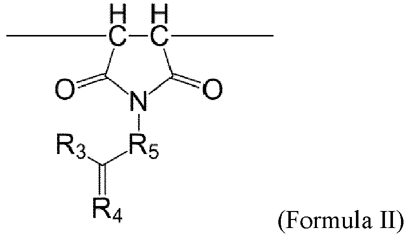 wherein R3 is H or an aliphatic group, R4 is an alkylidene group, and R5 is an alkylene group.
44. The thermoset resin composition of clause 42 or 43, wherein the styrene-maleimide copolymer further comprises a saturated imide monomer of Formula III, 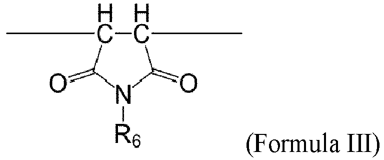 wherein R6 is a saturated aliphatic or an aromatic group.
45. The thermoset resin composition of any one of clauses 42-44, wherein the at least one curing agent comprises one or more maleimide group(s), (meth)acrylate group(s), and/or vinyl group(s).
46. The thermoset resin composition of any one of clauses 42-44, wherein the at least one curing agent comprises a polyfunctional maleimide.
47. The thermoset resin composition of clause 46, wherein the polyfunctional maleimide is selected from bisphenol A diphenyl ether bismaleimide, 3,3'-dimethyl-5,5'-diethyl-4,4'-diphenylmethane bismaleimide, biphenyl containing maleimide, meta-arylene containing maleimide, and 1,6-bismaleimide-(2,2,4-trimethyl)hexane.
48. The thermoset resin composition of any one of clauses 42-44, wherein the at least one curing agent is a polyfunctional (meth)acrylate.
49. The thermosetting resin composition of clause 48, wherein the polyfunctional (meth)acrylate is of the Formula XI, 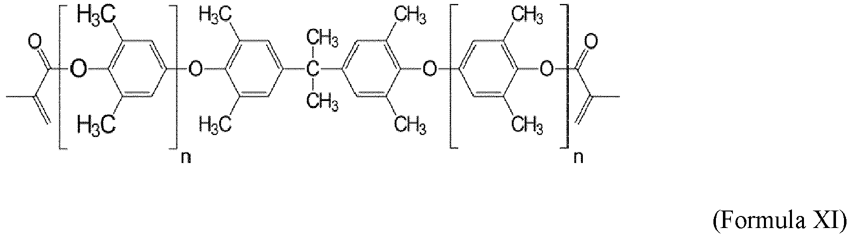 wherein n is an integer between 1-20.
50. The thermoset resin composition of any one of clauses 42-44, wherein the at least one curing agent is a polyfunctional vinyl containing curing agent.
51. The thermoset resin composition of clause 50, wherein the polyfunctional vinyl containing curing agent is selected from polybutadiene, polybutadiene-co-styrene, divinylbenzene, bis-vinylphenyl ethane, polyfunctional vinyl aromatic copolymer, vinyl cyclic olefin resin, and poly(arylene ether).
52. The thermoset resin composition of clause 51, wherein the poly(arylene ether) is of the Formula XII, 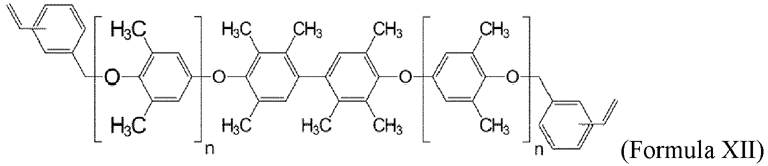 wherein n is an integer between 1-20.
53. The thermoset resin composition of any one of clauses 42-52, wherein styrene-maleimide copolymer is crosslinked by the at least one curing agent in the presence of one or more radical polymerization initiator.
54. The thermoset resin composition of clause 53, wherein the radical polymerization initiator comprises an azo compound or an organic peroxide.
55. The thermoset resin composition of clause 54, wherein the azo compound is azobisisobutyronitrile, 2,2'-azobis(2-methylbutyronitrile), 2,2'-azobis(2,4,4-trimethylpentane, 2,2'-azobis(N-butyl-2-methylpropionamide.
56. The thermoset resin composition of clause 55, wherein the organic peroxide is selected from the group consisting of benzoyl peroxide, t-butyl hydroperoxide, dicumyl peroxide, t-butyl perbenzoate, methylethyl ketone peroxide, cyclohexanone peroxide, acetyl peroxide, di-t-butyl peroxide, t-butyl perbenzoate, di(2-tert.butylperoxy-isopropyl)benzene, 2,5-dimethyl-2,5-di(tert.butylperoxy)hexyne-3), and cumene hydroperoxide.
57. The thermoset resin composition of any one of clauses 42-56, wherein styrene-maleimide copolymer is crosslinked by the at least one curing agent with heating.
58. The thermoset resin composition of any one of clauses 42-57, wherein the molar ratio of monomer unit of Formula I to the unsaturated imide monomer unit of Formula II in the styrene-maleimide copolymer is from about 1:1 to 9:1.
59. The thermoset resin composition of clause 58, wherein the molar ratio unsaturated imide monomer unit of Formula II to the saturated imide monomer unit of Formula III is from about 1:0 to 1:2.
60. The thermoset resin composition of any one of clauses 42-59, further comprising at least one additive selected from the group consisting of flame retardants, fillers, coupling agents, and a combination thereof.
61. The thermoset resin composition of any one of clauses 42-60, further comprising a substrate.
62. The thermoset resin composition of clause 61, wherein the a styrene-maleimide copolymer is not completely crosslinked by the least one curing agent, to provide a prepreg composition of the thermoset resin composition.
63. A metal clad laminate comprising the thermoset resin composition of clause 61 or 62, comprising one or more metal layers on the thermoset resin composition.
64. The metal clad laminate of clause 63 comprising,
   i.) an insulating layer comprising the thermoset rein of clause 61, and
   ii.) one or more metal layers. wherein the one or more metal layers are on either or both surfaces of the insulating layer.
65. A printed circuit board comprising the the thermoset resin composition of clause 62, or the metal clad laminate of clause 63 or 64.

### DETAILED DESCRIPTION

Before the present disclosure is further described, it is to be understood that this disclosure is not limited to particular embodiments described, as such may, of course, vary. It is also to be understood that the terminology used herein is for the purpose of describing particular embodiments only, and is not intended to be limiting, since the scope of the present disclosure will be limited only by the appended claims.

Unless defined otherwise, all technical and scientific terms used herein have the same meaning as is commonly understood by one of ordinary skill in the art to which this disclosure belongs. All patents, applications, published applications and other publications referred to herein are incorporated by reference in their entireties. If a definition set forth in this section is contrary to or otherwise inconsistent with a definition set forth in a patent, application, or other publication that is herein incorporated by reference, the definition set forth in this section prevails over the definition incorporated herein by reference.

As used herein and in the appended claims, the singular forms "a," "an," and "the" include plural referents unless the context clearly dictates otherwise. It is further noted that the claims may be drafted to exclude any optional element. As such, this statement is intended to serve as antecedent basis for use of such exclusive terminology as "solely," "only" and the like in connection with the recitation of claim elements, or use of a "negative" limitation.

As used herein, the terms "including," "containing," and "comprising" are used in their open, non-limiting sense.

To provide a more concise description, some of the quantitative expressions given herein are not qualified with the term "about." It is understood that, whether the term "about" is used explicitly or not, every quantity given herein is meant to refer to the actual given value, and it is also meant to refer to the approximation to such given value that would reasonably be inferred based on the ordinary skill in the art, including equivalents and approximations due to the experimental and/or measurement conditions for such given value. Whenever a yield is given as a percentage, such yield refers to a mass of the entity for which the yield is given with respect to the maximum amount of the same entity that could be obtained under the particular stoichiometric conditions. Concentrations that are given as percentages refer to mass ratios, unless indicated differently.

As used herein, the term "aliphatic" includes a composition of hydrocarbons that can be saturated, or unsaturated. Aliphatic compositions are not aromatic and do not possess alternating double bonds, e.g. pi-electron conjugation. Aliphatic compositions can comprise straight, branched, or cyclic hydrocarbons. Cyclic aliphatic compositions are not aromatic.

As used herein, the term "alkyl" refers to a mono-valent saturated aliphatic chain of carbon atoms, which is optionally branched and contains from 1 to 20 carbon atoms. It is to be further understood that in certain embodiments, alkyl may be advantageously of limited length, including C₁-C₁₂, C₁-C₁₀, C₁-C₉, C₁-C₈, C₁-C₇, C₁-C₆, and C₁-C₄, Illustratively, such particularly limited length alkyl groups, including C₁-C₈, C₁-C₇, C₁-C₆, and C₁-C₄, and the like may be referred to as "lower alkyl." Illustrative alkyl groups include, but are not limited to, methyl, ethyl, n-propyl, isopropyl, n-butyl, isobutyl, sec-butyl, tert-butyl, pentyl, 2-pentyl, 3-pentyl, neopentyl, hexyl, heptyl, octyl, and the like. Alkyl may be substituted or unsubstituted. Typical substituent groups include cycloalkyl, aryl, heteroaryl, heteroalicyclic, hydroxy, alkoxy, aryloxy, mercapto, alkylthio, arylthio, cyano, halo, carbonyl, oxo, (=O), thiocarbonyl, O-carbamyl, N-carbamyl, O-thiocarbamyl, N-thiocarbamyl, C-amido, N-amido, C-carboxy, O-carboxy, nitro, and amino, or as described in the various embodiments provided herein.

As used herein, the terms "alkylene" and "alkanediyl" refer to a di-valent a saturated aliphatic chain of carbon atoms, which is optionally branched and contains from 1 to 20 carbon atoms. It is to be further understood that in certain embodiments, alkylene or alkanediyl may be advantageously of limited length, including C₁-C₁₂, C₁-C₁₀, C₁-C₉, C₁-C₈, C₁-C₇, C₁-C₆, and C₁-C₄, Illustratively, such particularly limited length alkyl groups, including C₁-C₈, C₁-C₇, C₁-C₆, and C₁-C₄,, and the like may be referred to as "lower alkylene" or "lower alkanediyl." Illustrative alkylene or alkanediyl groups include, but are not limited to, methylene (methane-diyl), ethylene (ethane-1,2-diyl), n-propylene (propane-1,3-diyl), isopropylene (propane- 1,2-diyl), n-butylene (butane-1,4-diyl), sec-butylene (butane-1,3-diyl), n-pentylene (pentane-1,5-diyl), 2-pentylene (pentane-1,4-diyl), 3-pentylene (pentane-1,3-diyl), n-hexylene (hexane-1,6-diyl), n-heptylene (heptane-1,7-diyl), octylene (octane-1,8-diyl), and the like. Alkylene or alkanediyl may be substituted or unsubstituted. Typical substituent groups include cycloalkyl, aryl, heteroaryl, heteroalicyclic, hydroxy, alkoxy, aryloxy, mercapto, alkylthio, arylthio, cyano, halo, carbonyl, oxo, (=O), thiocarbonyl, O-carbamyl, N-carbamyl, O-thiocarbamyl, N-thiocarbamyl, C-amido, N-amido, C-carboxy, O-carboxy, nitro, and amino, or as described in the various embodiments provided herein.

As used herein, the term "cycloalkyl" includes an aliphatic ring of carbon atoms, which is optionally branched and contains from 3 to 20 carbon atoms. It is to be further understood that in certain embodiments, cycloalkyl may be advantageously of limited length, including C₃ to C₁₀, Illustrative cycloalkyl groups include, but are not limited to, cyclopropyl, cyclobutyl, cyclopentyl, cyclohexyl, cycloheptyl, cyclooctyl, and the like.

As used herein, the terms "alkenyl" and "alkynyl" refer to unsaturated aliphatic chains of carbon atoms. As used herein, the term "alkenyl" includes a chain of carbon atoms, which is optionally branched, and contains from 2 to 20 carbon atoms, and also includes at least one carbon-carbon double bond (i.e., C=C). It will be understood that in certain embodiments, alkenyl may be advantageously of limited length, including C₂-C₁₂, C₂-C₉, C₂-C₈, C₂-C₇, C₂-C₆, and C₂-C₄. Illustrative alkyenyl groups include, but are not limited to, vinyl, allyl, ethenyl, 1-propenyl, 2-propenyl, 1-, 2-, or 3-butenyl, and the like. As used herein, the term "alkynyl" includes a chain of carbon atoms, which is optionally branched, and contains from 2 to 20 carbon atoms, and also includes at least one carbon-carbon triple bond (i.e., C=C). It will be understood that in certain embodiments, alkynyl may each be advantageously of limited length, including C₂-C₁₂, C₂-C₉, C₂-C₈, C₂-C₇, C₂-C₆, and C₂-C₄ Illustrative alkynyl groups include, but are not limited to, ethynyl, 1-propynyl, 2-propynyl, 1-, 2-, or 3-butynyl, and the like.

As used herein, the term "alkylidene" refers to a divalent functional group derived from an alkane by removal of two hydrogen atoms from the same carbon atom, the free valencies being part of a double bond - R₂C=, with the carbon atom being sp² hybridized. The sp² carbon atom may be positioned at any carbon of the chain. Illustrative alkylidene groups include, but are not limited to, methylidene, ethylidene, 1-propylidene, 2-propylidene, and the like.

As used herein, the term "aryl" refers to an all-carbon monocyclic or fused-ring polycyclic groups of 6 to 12 carbon atoms having a completely conjugated pi-electron system, e.g. "aromatic". It will be understood that in certain embodiments, aryl may be advantageously of limited size such as C₆-C₁₀ aryl. Illustrative aryl groups include, but are not limited to, phenyl, naphthyl and anthracenyl. The aryl group may be unsubstituted or substituted, as described herein.

The term "substituted" means that the specified group or moiety bears one or more substituents. The term "unsubstituted" means that the specified group bears no substituents. Where the term "substituted" is used to describe a structural system, the substitution is meant to occur at any valency-allowed position on the system. In some embodiments, "substituted" means that the specified group or moiety bears one, two, or three substituents. In other embodiments, "substituted" means that the specified group or moiety bears one or two substituents. In still other embodiments, "substituted" means the specified group or moiety bears one substituent. Typical substituent groups include alkyl, cycloalkyl, aryl, hydroxy, alkoxy, aryloxy, mercapto, alkylthio, arylthio, cyano, halo, carbonyl, oxo, (=O), thiocarbonyl, nitro, and amino, or as described in the various embodiments provided herein.

One object of the present disclosure is achieved in that a thermosetting resin composition is provided comprising a copolymer comprising monomer units of Formula I and an aliphatic unsaturated imide of Formula II and at least one curing agent comprising maleimide, (meth)acrylate or vinyl groups. 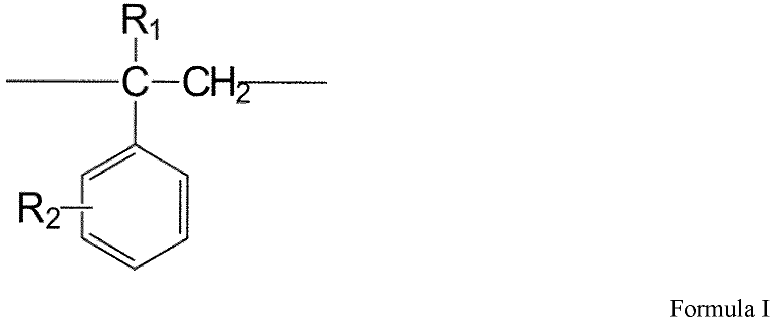 wherein R1 represents a hydrogen or aliphatic group, R2 represents a hydrogen, an aliphatic or aromatic group, preferably R1 is methyl or H, R2 is H. 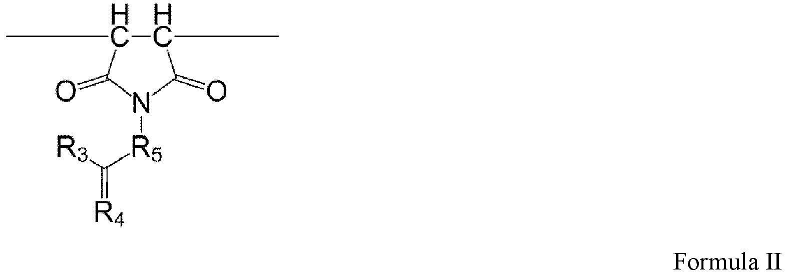 wherein R3 is H or an alkyl group, R4 is an alkyl group, R5 is an alkyl group. Preferably R3 is H or a C1-C8 alkyl group, R4 is a C1-C4 alkylidene group, R5 is a C1-C4 alkanediyl group. More preferably R3 is H, R4 is CH2, R5 is CH2.

Surprisingly it has been found that the thermosetting resin compositions of the present disclosure have a low dielectric loss (Df) at high frequency, such as 5 GHz . Furthermore, the thermosetting resin compositions of the present disclosure show improved thermostability. With a low dielectric loss according to the present disclosure is meant a dielectric constant (Dk) of less than 2.7 preferably less than 2.6 in the highfrequency band, e.g. above 5 GHz and a dielectric loss (Df) of less than 0.0040, preferably less than 0.0030, more preferably less than 0.0020.

With an improved thermostability according to the present disclosure is meant that high thermal decomposition temperature of the cured resin systems, such as the thermal decomposition temperature is above 350 °C at which the mass of the cured sample is 5.0% less than its mass measured at 50°C via thermogravimetric analysis (TGA), i.e. Td 5%.

The glass transition temperature (T_{g}) of the cured resin compositions according to the present disclosure is at least above 110 °C, preferably above 150 °C and more preferably is above 170 °C. The Tg of the cured resin composition can be measured via Differential scanning calorimetry (DSC), Dynamic mechanical analysis (DMA) or Thermomechanical Analysis (TMA).

The molar ratio of the monomer unit of Formula I versus the aliphatic unsaturated imide monomer unit of Formula II varies from 1:1 to 9:1. Preferably the molar ratio varies from 3:1 to 8:1.

The weight average molecular weight (g/mol) of the copolymers may range from 4.000-80.000, preferably from 4.500-30.000, more preferably from 7.000-20.000.

As used herein, "polymer" means a substance or material composed of many repeating subunits, or "monomers". As used herein, "copolymer" means a polymer composed of more than one monomer.

In the thermosetting resin composition of the present disclosure the copolymer of monomer units of Formula I and aliphatic unsaturated imide monomer units of Formula II may optionally be combined with a saturated imide monomer unit Formula III. The introduction of saturated imide monomer unit of Formula III may change the thermal and dielectric properties of the copolymer depending on the choice of R6. 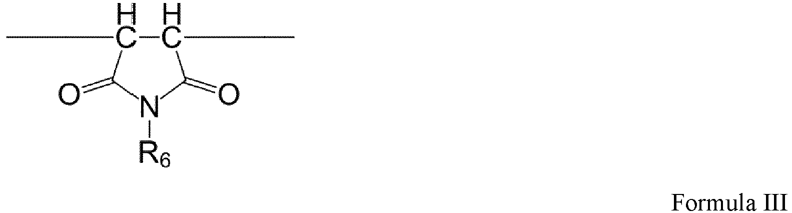 Whereby R6 is chosen from saturated aliphatic or aromatic groups. Preferably R6 is chosen from methyl, ethyl, propyl, cyclohexyl, benzyl, phenyl, substituted phenyl or naphthyl.

The molar ratio of the monomer unit of Formula I versus the combined aliphatic unsaturated imide monomer unit of Formula II and the saturated imide monomer unit of Formula III varies from 1:1 to 9:1. Preferably the molar ratio varies from 3:1 to 8:1. The molar ratio of aliphatic unsaturated imide monomer unit of Formula II versus the saturated imide monomer unit of Formula III varies from 1:0 to 1:2.

Preferably the thermosetting resin composition according to the present disclosure comprises a copolymer according to Formula IV or V. 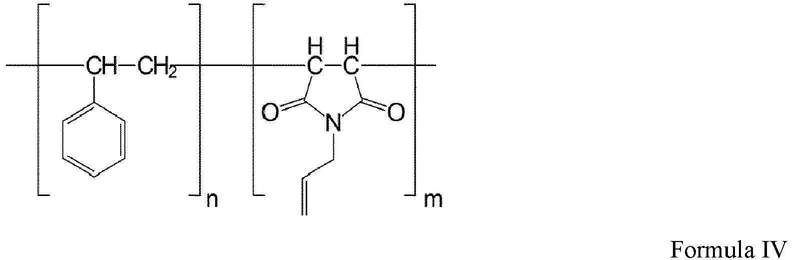 Wherein the molar ratio of n:m range from 1:1 to 9:1. 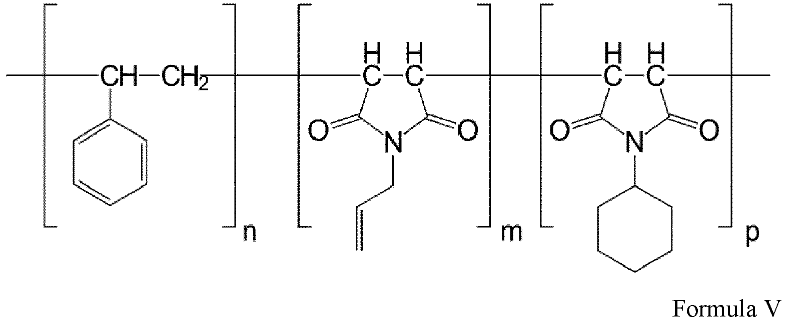 Wherein the molar ratio of n:(m+p) range from 1:1 to 9:1; m:p range from 1:0 to 1:2.

The synthesis of the described copolymer is not particularly limited. For example, aliphatic unsaturated maleimide such as N-allyl maleimide can be copolymerized with for example styrene as disclosed in US4795692. Alternatively, a copolymer comprising a monomer unit of Formula I and an anhydride monomer unit of Formula VI can be imidized using an unsaturated aliphatic amine.

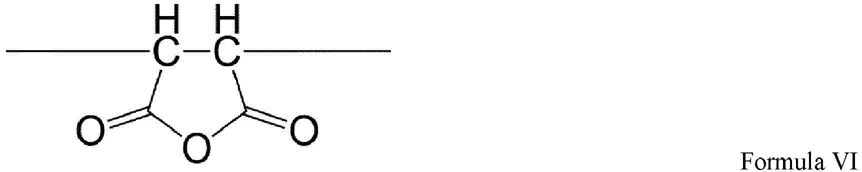

Examples of unsaturated aliphatic amines but not limited to are allylamine, methallylamine and butenylamine. Optionally a saturated aliphatic or aromatic amine can be used in combination with the unsaturated amines. The imidization process is known by a person skilled in the arts and is not particularly limited. It can be performed in solvent, water or in melt at atmospheric pressure or at elevated pressure. Optionally, a catalyst can be added to promote the imidization reaction such as a tertiary amine like tri-ethylamine. Preferably a styrene-maleic anhydride copolymer (SMA) is imidized with allylamine. The weight average molecular weight (g/mol) of the SMA copolymers may range from 4.000-80.000, preferably from 4.500-30.000, more preferably from 7.000-20.000 and the molar ratio of styrene and MA varies from 1:1 to 9:1, preferably from 3:1 to 8:1.

The purification methods of the imidized polymer is not particularly limited and may consist of one or more of the following methods, i.e. distillation of reaction solvent, precipitation, filtration, washing and drying.

The thermosetting resin composition of the present disclosure comprises at least one curing agent comprising maleimide, (meth)acrylate or vinyl groups.

As used herein, "cross-linked" means the covalent linkage between polymer chains, either directly or through one or more "curing agent(s)" as described herein. As used herein, "curing agent(s)" means a chemical entity containing one or more functional groups that when added to a polymer and can provide a "cured" or "cross-linked" polymer.

Curing agents comprising maleimide groups may contain one or more maleimide groups per molecule. Monofunctional maleimides have one maleimide group per molecule such as N-phenylmaleimide or N-cyclohexylmaleimide. Polyfunctional maleimides contain two or more maleimide groups per molecule. The maleimide curing agents are preferably soluble in commonly used solvents like Methyl ethyl ketone (MEK) and/or Toluene. Preferably the curing agent is a polyfunctional maleimide resin. Examples of polyfunctional maleimides are but not limited to 3,3'-dimethyl-5,5'-diethyl-4,4'-diphenylmethane bismaleimide of Formula VII, bisphenol A diphenyl ether bismaleimide of Formula VIII, biphenyl containing maleimide such as MIR-3000 from Nippon Kayaku of Formula IX, a meta-arylene containing maleimide such as MIR-5000 from Nippon Kayaku of Formula X 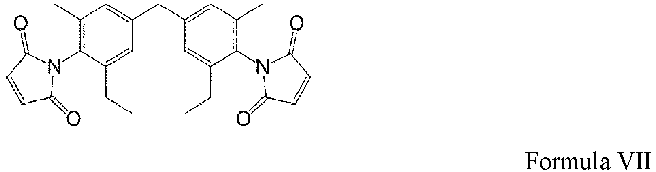 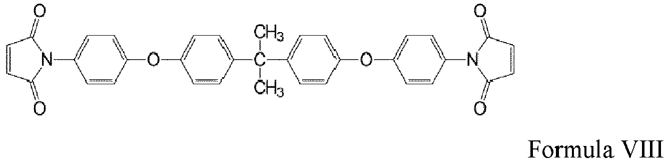 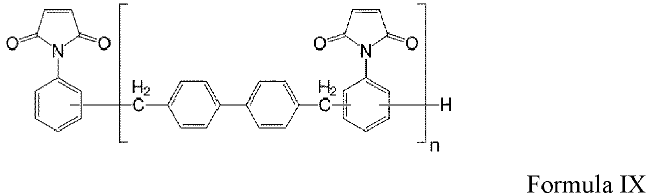 Wherein 1 < n ≤ 5 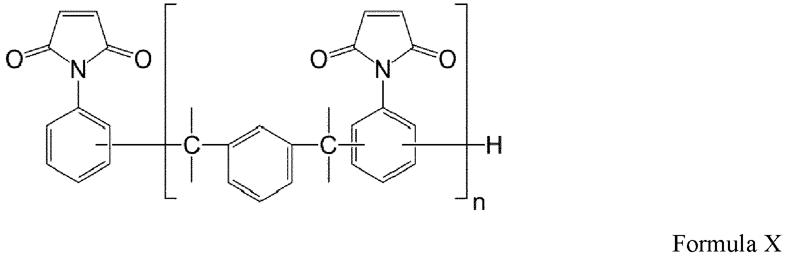 Wherein 1 < n < 5

Further examples of curing agents comprising maleimide groups are oligomers of phenylmethane maleimide, aliphatic bismaleimide such as 1,6-bismaleimide-(2,2,4-trimethyl) hexane available from Daiwa Kasei or non-hydrogenated dimer containing BMI available from BMI-689 from Designer Molecules. Chain extended bismaleimide is also possible whereby a dianhydride is used in the BMI manufacturing process. BMI-3000 from Designer Molecules is an example of a commercially available chain extended bismaleimide.

Curing agents comprising (meth)acrylic groups may contain one or more (meth)acrylic groups per molecule. Preferably polyfunctional (meth)acrylate are used as curing agent. Examples of polyfunctional (meth)acrylate include but not limited to tricyclodecane dimethanol dimethacrylate and (meth)acrylate functional poly(arylene ether). The poly(arylene ether) is not particularly limited but preferably contains two or more (meth)acrylic groups per molecule. SA9000 is commercially available from SABIC which is a poly(arylene ether) containing methacrylic end-groups of Formula XI. 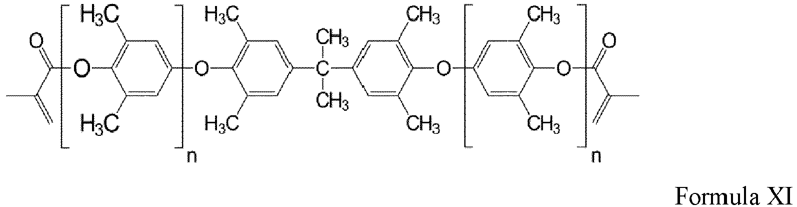 n is an integer between 1-20.

Curing agents comprising vinyl groups may contain one or more vinyl groups per molecule. Preferably polyfunctional vinyl containing curing agents are used. Examples of polyfunctional vinyl containing curing agents are polybutadiene, polybutadiene-co-styrene, divinylbenzene, bis-vinyl-phenyl ethane, polyfunctional vinyl aromatic copolymer, vinyl cyclic olefin resin and poly(arylene ether). The poly(arylene ether) is not particularly limited but preferably contains two or more vinyl groups per molecule such as OPE-2St which is commercially available from MGC and represented in Formula XII. 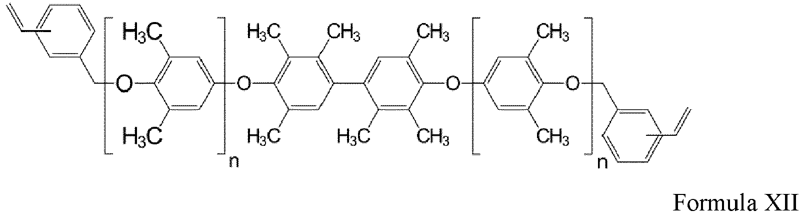 n is an integer between 1-20.

In addition to the maleimide, (meth)acrylate or vinyl containing curing agents an additional curing agent comprising allyl groups may be used. Preferably a polyfunctional allyl containing curing agent is used. Examples of polyfunctional allyl containing curing agents are triallylisocyanurate (TAIC), trimethallylisocyanurate (TMAIC), diallyl alkylIsocyanurate and diallylphthalate.

Optionally a radical polymerization initiator is present in the thermosetting resin composition of the present disclosure. Commonly used examples of initiators are azo compounds and organic peroxides such as azobisisobutyronitrile, 2,2'-azobis(2-methylbutyronitrile), 2,2'-azobis(2,4,4-trimethylpentane, 2,2'-azobis(N-butyl-2-methylpropionamide, benzoyl peroxide, t-butyl hydroperoxide, dicumyl peroxide, t-butyl perbenzoate, methylethyl ketone peroxide, cyclohexanone peroxide, acetyl peroxide, di-t-butyl peroxide, t-butyl perbenzoate, di(2-tert.butylperoxyisopropyl)benzene, 2,5-dimethyl-2,5-di(tert.butylperoxy)hexyne-3) and cumene hydroperoxide. These initiators may be used single or in a mixture of two or more of them. The kind and amount of the initiator to be used may be changed depending on the intended use of the thermosetting resin composition and the curing conditions required. Preferably the initiator may be used in an amount of 0.001 to 5 percent by weight, preferably 0.001 to 1.0 percent by weight based on the resin composition.

The thermosetting resin composition may further comprise additives. The additives may include but are not limited to, (reactive) flame retardants, fillers, coupling agents and any combination thereof for further improving the various properties of the thermosetting resin composition.

Examples of flame retardants are ethylene-1,2-bis(penta-bromo-phenyl) known as SAYTEX 8010 available from Albemarle and ethylene-bis-tetra-bromo-phthalimide known as SAYTEX BT93(W) available from Albemarle. An example of a halogen free flame retardant is bis (DOPO) derivative XP7866 from Albemarle.

Examples of fillers include, but are not limited to, inorganic fillers such as silica, alumina, barium sulfate, talc, mica, kaolin, boehmite, beryllia, barium titanate, potassium titanate, strontium titanate, calcium titanate, aluminum carbonate, magnesium hydroxide, aluminum hydroxide, aluminum borate, aluminum silicate, calcium carbonate, calcium silicate, magnesium silicate, zinc borate, zinc stannate, aluminum oxide, zirconia, mullite, magnesia, zinc oxide, titanium oxide, silicon carbide, silicon nitride and boron nitride.

The inorganic filler can be used without a surface treatment or can be surface-treated with a silane coupling agent of e.g., methacrylic silane type, vinyl silane type, phenyl aminosilane type or epoxy silane type. Alternatively, the silane coupling agent may be added separately to the resin formulation containing inorganic filler.

The thermoset resin compositions of the present disclosure are particularly useful in the preparation of prepregs and/ or metal clad laminates and printed circuit boards, which require low dielectric constants and low dielectric loss ("low loss").

As used herein, the term "prepreg" refers to a composite material made from "pre-impregnated" substrate and the resin composition or the semi-cured product of the resin composition.

The present disclosure further relates to prepregs comprising the thermosetting resin composition of the present disclosure. Prepregs include a reinforcing substrate and an un-cured or semi-cured thermosetting resin composition therein. With regard to the reinforcing substrate of the prepreg, known materials such as natural fibers for example paper but also inorganic fibers such as glass fibers. Illustrative example of the glass fiber substrate includes a woven fabric using E glass, C glass, D glass, S glass, NE glass, L glass, Q glass. E glass woven fabric is commonly used. In some embodiments to achieve lower dielectric loss NE-glass, or L glass, or Q-glass is preferred.

As used herein, the "semi-cured" state refers to an intermediate stage (Stage B). The intermediate stage is a stage between a stage in the uncured resin composition (Stage A) and a stage in a fully cured state (Stage C). Heating the prepreg allows the resin compositions to be cured fully to turn into a cured product.

The reinforcing substrates have the form of woven fabric, unwoven fabric, roving, chopped strand mat, surfacing mat, or the like. Meanwhile, the material and form thereof are chosen depending on the use or performance of the target shaped material, wherein they may be used singly or, if necessary, in a combination of two or more of the material and form thereof.

In this specification the resin composition including an organic solvent is called a resin varnish. The organic solvent is not particularly restricted as long as it the dissolves the copolymer, the curing agent and the like. Examples are ketone-based solvents such as acetone, 2-butanone (MEK) and cyclohexanone and hydrocarbon based solvents for example toluene, xylene and anisole. These organic solvents may be used singly or concurrently as a mixture of two or more of them. Non-soluble additives such as silica particles and potentially additive based flame retardant can be dispersed in the resin varnish.

The prepreg can be produced, for example, in such a way that firstly the reinforcing substrate is impregnated by the resin vanish and secondly the solvents are removed. The solvents are removed by heating the impregnated reinforced substrate. The temperature is preferably in the range of 80 to 200 °C, because in this temperature range the organic solvent can be efficiently removed. Meanwhile, the prepreg obtained by such process can contain an uncured or semi-cured intermediate depending on the selected drying conditions, while the prepreg after being converted to the C-stage is regarded as the fully cured laminate.

The disclosure also relates to metal clad laminates comprising the thermosetting resin composition according to the present disclosure. Metal-clad laminates, particularly copper clad laminates for use in fabricating printed circuit boards are well-known in the art. The laminate generally comprises a (polymeric) substrate to which is bonded at least one thin sheet (foil) of an electrically conductive material such as copper. The substrate can be clad with the metal foil on one or both sides, depending upon the desired use, and can be rigid or flexible depending upon the composition of the substrate, the choice of reinforcement (if any), and the intended use of the laminate. Preferably the polymeric substrate comprises the thermosetting resin composition of the present disclosure.

The disclosure further relates to printed circuit boards comprising the prepreg and/or metal clad laminates comprising the thermosetting resin composition according to the present disclosure.

The thermoset resin compositions of the present disclosure can be used in the high speed PCB applications, such as, servers, switches, routers, backplane of base stations, or in other applications like radomes, automotive radar antenna covers, antenna substrates, microchip packaging especially for 5G applications.

The present disclosure will now be described in detail with reference to the following non-limiting examples which are by way of illustration.

**List of abbreviations and chemicals**

| | |
|---|---|
| MEK | 2-butanone, methyl ethyl ketone |
| Luperox F | 1,3(4)-bis[1-(tert-butylperoxy)-1-methylethyl]benzene |
| BMI-5100 | 3,3'-dimethyl-5,5'-diethyl-4,4'-diphenylmethane bismaleimide |
| TAIC | triallyl isocyanurate |
| RICON^{®} 181 | low molecular weight, liquid copolymer of butadiene and styrene |
| SMA | poly(styrene-co-maleic anhydride), styrene-maleic anhydride copolymer |
| PPE | poly(phenylene ether) |
| PTFE | Polytetrafluoroethylene |
| Dk | dielectric constant |
| Df | dielectric loss |
| Tg | Glass Transition temperature |
| CCL | copper-clad laminates |
| PCB | printed circuit boards |

Xylene was supplied by Carl Roth. Allylamine, acetone, and MEK were supplied by Sigma Aldrich. Noryl SA9000 is available from SABIC. XIRAN EF-grades are available from Polyscope. BMI-5100 is available from Daiwa Kasei. RICON^{®} 181 is available from Cray Valley.

### BRIEF DESCRIPTION OF DRAWINGS

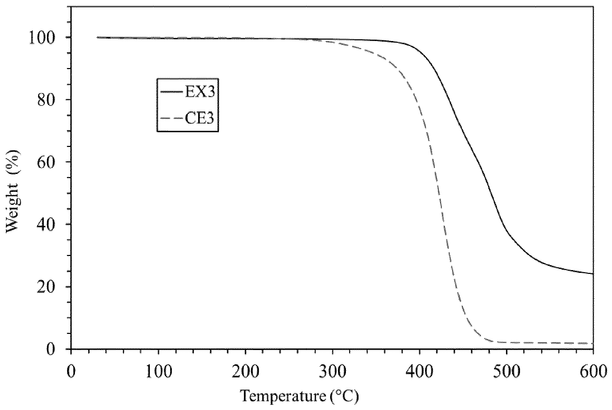

Fig. 1 is a graph of a TGA curve for Example 3 and Comparative example 3.

### TEST ITEMS AND TEST METHODS

### Neat resins

Fourier transform infrared spectroscopy (FTIR) was performed using an ALPHA II FT-IR spectrometer from Bruker equipped with a PLATINUM-ATR module.

Size exclusion chromatography (SEC) was using a PSS WinGPC system from PSS. A Precolumn guard of 5 µm, 8.0 mm × 50 mm was used followed by three columns of 1000 Å, 8.0 mm × 300 mm, 8.0 mm × 300 mm. A differential refractometer (RID) was used as detector. The eluent was THF with 5 % acetic acid. An injection volume of 100 µL and the flow rate was 1.0 ml/min. The sample concentration was 5 g/L. The temperature was 23 °C. The molecular weight was calculated by using calibrated polystyrene molar mass standards.

### Neat resin castings:

The Dk and Df were measured at 5.1 GHz at room temperature using a split post dielectric resonator (SPDR) equipped with a Microwave Frequency Q-Meter (5 GHz) from QWED. The neat resin castings were measured directly after post baking at 200 °C for 1 hour.

Differential scanning calorimetry (DSC) was performed using a DSC 2 STARe from METTLER TOLEDO. The DSC measurements were carried out on the prepared neat resin castings from 30 °C to 220 °C using a heating rate of 20 °C/min and a cooling rate of 10 °C/min under a nitrogen flow of 50 mL/min). The second heating rate was carried out at 20 °C/min from 30 to 250 °C. The sample weight was approximately 10 mg. Data analysis was performed using STARe software. The cross-linked Tg values of the prepared neat resin castings were determined using the midpoint function with the data of the second heating run.

Thermogravimetric analysis (TGA) was performed using a TGA 2 STARe from METTLER TOLEDO. The TGA samples were first dried using the TGA by a heating rate of 10 °C/min from 30 °C to 200 °C under nitrogen flow of 50 mL/min. Subsequently, the dried sample was measured in the TGA using a heating rate of 10 °C/min from 30 °C to 700 °C under nitrogen flow of 50 mL/min. Data analysis was performed using STARe software. The Step Horizon Function (start temperature of 50 °C) was used to determine the thermal decomposition temperature at 5 mass percentage weight loss and the residue at 600 °C.

### EXAMPLES AND COMPARATIVE EXAMPLES

### Example 1 (Synthesis of XIRAN EL819)

XIRAN EF80 (0.201 mol anhydride) was added to a 1000 mL four-necked round bottom flask equipped with a Dimroth condenser, a mechanical stirrer, a nitrogen inlet and pressure equalizing dropping funnel. 360 g of xylene was charged into the round bottom flask. 0.221 mol allylamine was slowly added. The reaction temperature was increased to 40 °C for 1.5 hours to form the amic acid. Subsequently, 0.050 mol of triethylamine (TEA) was added and the reaction mixture was heated to reflux. The solution was refluxed for 12 hours and cooled down to room temperature. An additional 0.060 mol of allylamine was added. The reaction mixture was increased to 40 °C for 1.5 hours. 0.004 mol TEA was added and the solution was refluxed for an additional 12 hours. The solution was cooled down to room temperature and the solvent was removed in a rotary evaporator and the obtained resin powder was dried further over night in a vacuum oven at 80 °C. FT-IR analysis indicated the presence of imide groups and allyl groups. The modified polymer is soluble in commonly used solvents including acetone, MEK, toluene, xylene and anisole. As indicated by SEC measurements, no chain extension or crosslinking of the modified polymer occurred.

### Example 2 (Synthesis of XIRAN EL419)

XIRAN EF40 (0.321 mol anhydride) was added to a 1000 mL four-necked round bottom flask equipped with a Dimroth condenser, a mechanical stirrer, a nitrogen inlet and pressure equalizing dropping funnel. 394 g of xylene was charged into the round bottom flask. 0.353 mol allylamine was slowly added. The reaction temperature was increased to 40 °C for 1.5 hours to form the amic acid. Subsequently, 0.064 mol of triethylamine (TEA) was added and the reaction mixture was heated to reflux. The solution was refluxed for 12 hours and cooled down to room temperature. An additional 0.060 mol of allylamine was added. The reaction mixture was increased to 40 °C for 1.5 hours. 0.005 mol TEA was added and the solution was refluxed for an additional 12 hours. The solution was cooled down to room temperature and the solvent was removed in a rotary evaporator and the obtained resin powder was dried further over night in a vacuum oven at 80 °C. FT-IR analysis indicated the presence of imide groups and allyl groups. The modified polymer is soluble in commonly used solvents including acetone, MEK, toluene, xylene and anisole. As indicated by SEC measurements, no chain extension or crosslinking of the modified polymer occurred.

### Preparation method varnishes and neat resin castings

First, varnishes are prepared by dissolving the components in MEK according to the formulations presented in Tables 1 and 3. Once all the components were dissolved, the solvent was removed overnight at 65 °C under vacuum in an oven to obtain a resin powder. The obtained resin powder is used to make neat resin casting using a vacuum hot press with a hot press curing schedule of 1.5 hours at 220 °C. Example 4 was thermally cross-linked without an initiator using a hot press curing schedule of 1.5 hours at 240 °C. The neat resin castings were removed from the mold and post-baked for an additional 1 hour at 200 °C in an vacuum oven. The neat resin castings thickness is approximately 1 mm.

### Results of examples and comparative examples

The resin compositions (parts per hundred resin) of the prepared neat resin castings and the tested dielectric results are presented in below Tables 1 and 3 and in Figure 1.

In Figure 1 a TGA curve is given of Example 3 and Comparative example 3. As can be seen from the figure, Ex 3 shows an improved thermostability at temperatures of 300 °C or higher.

**TABLE 1**

| Below Table 1 refers to examples 1-5 and comparative examples 1-3 comprising the indicated formulations. | | | | | | | | |
|---|---|---|---|---|---|---|---|---|
| | Ex 1 | Ex 2 | Ex 3 | Ex 4 | Ex 5 | CE 1 | CE 2 | CE 3 |
| XIRAN EL 819 | 80 | 60 | 50 | 80 | 45 | | | 100 |
| BMI-5100 | 20 | 40 | 40 | 20 | | 35 | 20 | |
| SA9000 | | | | | 55 | 50 | 80 | |
| TAIC | | | 10 | | | | | |
| RICON181 | | | | | | 15 | | |
| Luperox F | 0.8 | 0.8 | 0.8 | | 0.8 | 0.8 | 0.8 | 0.8 |
| Dk (5.1 GHz) | 2.57 | 2.58 | 2.61 | 2.61 | 2.55 | 2.61 | 2.71 | * |
| Df (5.1 GHz) | 0.0019 | 0.0026 | 0.0022 | 0.0012 | 0.0038 | 0.0047 | 0.0121 | * |

| | | | | | | | | |
|---|---|---|---|---|---|---|---|---|
| ^{∗}-- not able to determine the dielectric properties (Deformed during post-cure) | | | | | | | | |

As is clear from Table 1, Ex 1-5 show excellent dielectric properties with Df values ranging from 0.0012-0.0038. The allyl modified copolymers can thermally cross-link with maleimide without a radical initiator (Ex 4) and this resulted into a reduced dielectric loss value compared to Ex 1. The dielectric loss of CE2 is surprisingly high with a Df value 0.0121. The dielectric properties of CE 1 with the addition RICON181 is better than CE 2, however the Dk and Df values are still higher compared to the those of the examples Ex 1-5. Dielectric properties of CE3 could not be measured due to the deformation of the neat resin casting during the post-cure in the vacuum oven.

### TABLE 2 The thermal properties of the selected neat resin castings

Examples Ex 1-5 all show a large improvement of the Td5 and have substantial higher residue at 600 °C compared to Comparative example 3.

**TABLE 2**

| | Td,5% (°C) | Residue at 600 °C (wt%) |
|---|---|---|
| Ex 1 | 380.5 | 14.52 |
| Ex 2 | 396.3 | 25.18 |
| Ex 3 | 402.6 | 24.12 |
| Ex 4 | 386.6 | 15.34 |
| Ex 5 | 388.4 | 18.53 |
| CE 3 | 347.6 | 1.78 |

The examples E1-E5 all show a large improvement of the Td5 and have substantial higher residue at 600 °C compared to Comparative example C3.

### TABLE 3 Dielectric properties and Tg of neat resin castings

Table 3 refers to examples 6-8 comprising the indicated formulations.

The formulations containing Xiran EL419 have the Df below 0.003. With increasing of BMI 5100 proportion in the formulations, Df values of the cured resin systems have little changes, but the T_{g} values increase with increasing in BMI 5100.

**TABLE 3**

| | Ex 6 | Ex 7 | Ex 8 |
|---|---|---|---|
| XIRAN EL-419 | 90 | 80 | 70 |
| BMI-5100 | 10 | 20 | 30 |
| Luperox F | 0.8 | 0.8 | 0.8 |
| Dk (5.1 GHz) | 2.63 | 2.66 | 2.63 |
| Df (5.1 GHz) | 0.0028 | 0.0028 | 0.0025 |
| Tg (°C, DSC) | 150 | 171 | 181 |

## Claims

1. A thermosetting resin composition comprising a copolymer comprising a monomer unit of Formula I 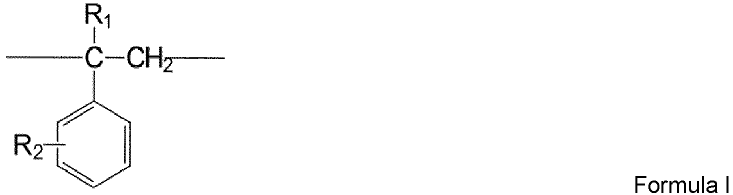 wherein R1 represents a hydrogen or aliphatic group and R2 represents a hydrogen, an aliphatic or aromatic group, and an aliphatic unsaturated imide of Formula II 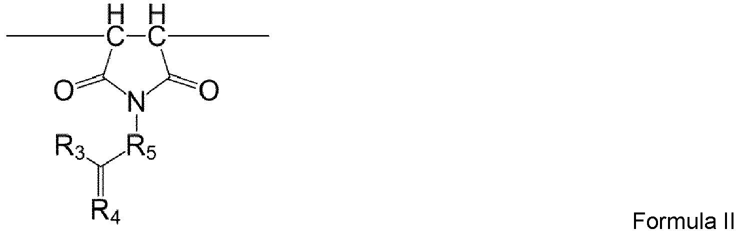 wherein R3 is H or an alkyl group, R4 is an alkylidene group and R5 is an alkanediyl group and at least one curing agent comprising maleimide, (meth)acrylate or vinyl groups.

2. The thermosetting resin composition according to claim 1 whereby the maleimide curing agent is a polyfunctional maleimide.

3. The thermosetting resin composition according to claim 2 whereby the polyfunctional maleimide is chosen from the group consisting of bisphenol A diphenyl ether bismaleimide, 3,3'-dimethyl-5,5'-diethyl-4,4'-diphenylmethane bismaleimide, biphenyl containing maleimide, meta-arylene containing maleimide or 1,6-bismaleimide-(2,2,4-trimethyl)hexane.

4. The thermosetting resin composition according to any one of the claims 1-2 whereby the curing agent comprising (meth)acrylate groups is a polyfunctional (meth)acrylate.

5. The thermosetting resin composition according to claim 4 whereby the polyfunctional (meth)acrylate is represented by Formula XI 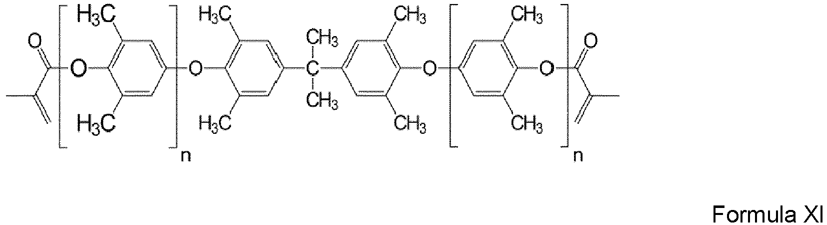 n is an integer between 1-20.

6. The thermosetting resin composition according to any one of the claims 1-2 whereby the curing agent comprising vinyl group is a polyfunctional vinyl containing curing agent.

7. The thermosetting resin composition according to claim 6 whereby the polyfunctional vinyl curing agent is selected from the group consisting of polybutadiene, polybutadiene-co-styrene, divinylbenzene, bis-vinylphenyl ethane, polyfunctional vinyl aromatic copolymer, vinyl cyclic olefin resin or a poly(arylene ether).

8. The thermosetting resin composition according to claim 7 whereby the poly(arylene ether) is represented by Formula XII. 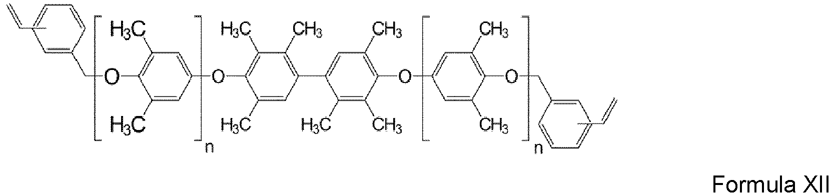 n is an integer between 1-20.

9. The thermosetting resin composition according to any one of the claims 1-8 further comprising a radical initiator.

10. The thermosetting resin composition according to claim 1 whereby the molar ratio of monomer unit of Formula I versus the unsaturated imide monomer unit of Formula II varies from 1:1 to 9:1.

11. The thermosetting resin composition according to claim 1 whereby the copolymer further comprises saturated imide monomer units of Formula III. 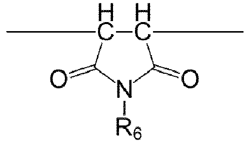 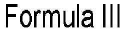 Whereby R6 is chosen from saturated aliphatic or aromatic groups.

12. The thermosetting resin composition according to claim 11 whereby the molar ratio unsaturated imide monomer unit of Formula II versus the saturated imide monomer unit of Formula III varies from 1:0 to 1:2.

13. The thermosetting resin composition according to any one of the claims 1-12 further comprising at least one additive selected from flame retardants, fillers, coupling agents and any combination thereof.

14. A prepreg comprising the thermosetting resin composition according to any one of the claims 1-13 or a semi-cured product of the resin composition and a substrate.

15. Metal clad laminate comprising an insulating layer formed out of a cured product of the prepreg of claim 14 and at least one metal layer formed on either or both surfaces of the insulating layer.

16. Printed circuit board comprising the metal clad laminate according to claim 15.
